# EUROPEAN PATENT SPECIFICATION

(11) **EP 0 512 798 B1**
(45) Date of publication and mention of the grant of the patent: **09.09.1998**
(21) Application number: 92304050.5
(22) Date of filing: 06.05.1992
(51) Int. Cl.: G01R 33/48, G01R 33/56

(54) **Method and apparatus for rapid magnetic resonance imaging**
Verfahren und Vorrichtung für schnelle Bildgebung mittels magnetischer Resonanz
Procédé et appareil pour la formation rapide d'image de résonance magnétique

(30) Priority: 08.05.1991 JP 102376/91
(43) Date of publication of application: 11.11.1992
(73) Proprietor: KABUSHIKI KAISHA TOSHIBA, Kawasaki-shi, Kanagawa-ken 210 (JP)
(72) Inventor: Seo, Yasutsugu, c/o Intellectual Property Div., Minato-ku, Tokyo (JP); Moriya, Eiji, c/o Intellectual Property Div., Minato-ku, Tokyo (JP)
(74) Representative: BATCHELLOR, KIRK & CO.

(56) References cited:
- EP-A- 349 976
- EP-A- 414 318
- US-A- 4 710 717
- US-A- 4 767 991
- MAGNETIC RESONANCE IN MEDICINE. vol. 11, no. 1, 1 July 1989, DULUTH,MN US pages 98 - 113; D.L. PARKER ET AL.: 'EFFICIENT BIPHASIC SPIN-ECHO MAGNETIC RESONANCE IMAGING'
- MAGNETIC RESONANCE IN MEDICINE. vol. 12, no. 3, 1 December 1989, DULUTH,MN US pages 306 - 315; P. WEBB ET AL.: 'A FAST SPECTROSCOPIC IMAGING METHOD USING A BLIPPED PHASE ENCODE GRADIENT'
- JOURNAL OF PHYSICS E. SCIENTIFIC INSTRUMENTS. vol. 19, no. 6, 1 June 1986, ISHING, BRISTOL GB pages 439 - 444; M. DOYLE ET AL.: 'REAL-TIME MOVIE IMAGE ENHANCEMENT IN NMR'

## Description

The present invention relates to an apparatus and a method for obtaining magnetic resonance images, more specifically, an apparatus employing a pulse sequence for rapid imaging.

A number of investigations have been done to reduce the imaging time of a magnetic resonance imaging apparatus especially for imaging the heart or abdominal organs. A pulse sequence called "Echo Planar Imaging (EPI)" method is well-known as a rapid imaging sequence which enable to obtain an image in sub-seconds. In addition, there are some other rapid sequences, for example, "Rapid Acquisition with Relaxation Enhancement (RARE)" method and "Gradient and Spin Echo (GRASE)" method disclosed respectively 3, 828-833, 1986 and 20, 344-349, 1991, both in Magnetic Resonance in Medicine.

A method for improving the spatial resolution in EPI method has been shown by Rzedzian in U.S. Patent No. 4,767,991, which method is called "Mosaic Scan" or "Interleave Scan". The Fourier space is divided into a plurality of trajectories. In each trajectory a plurality of magnetic resonance signals are obtained by one excitation pulse. Trajectories fill the Fourier space similar to a mosaic work in Mosaic Scan, or interleaving each other in Interleave Scan, and these trajectories produce a magnetic resonance image. In this method, the more trajectories in the Fourier space, the more the spatial resolution is improved, since the spatial resolution is proportional to the number of the sampling points when the sampling pitch is constant. A similar method is disclosed in EP-A-0414318. However, the frame rate, which indicates the number of images obtained per unit time, is worse since the whole sampling time is longer.

Accordingly, it is an object of the present invention to provide an improved magnetic resonance imaging apparatus with an improved frame rate employing Mosaic Scan or Interleave Scan.

In accordance with the present invention, the foregoing object is achieved by a method for magnetic resonance imaging comprising the steps of:
(a) applying a static magnetic field;
(b) applying an excitation pulse with a gradient field to excite nuclear spins in a region to be examined;
(c) reversing the direction of said excited nuclear spins repeatedly to induce a plurality of echo signals, said echo signals corresponding to a predetermined trajectory on the Fourier space, each of said echo signals having a different phase encoding;
(d) sampling said echo signals;
characterised by the steps of:
(e) repeating the steps (b)-(d) to obtain sets of echo signal data of a plurality of different trajectories which are interleaved with one another;
(f) repeating a cycle of the steps (b)-(e) to obtain further sets of echo signal data on the same trajectories as the previous cycle;
(g) replacing each set of trajectory data obtained in the step (e) in turn, by the corresponding set of trajectory data obtained in step (f), both sets of trajectory data being located on the same trajectory; and
(h) reconstructing a fresh magnetic resonance image each time one of the sets of data has been replaced.

The invention also extends to an apparatus for magnetic resonance imaging comprising:
static field generating means for generating a static magnetic field in a region to be examined;
gradient field generating means for generating a gradient magnetic field according to a predetermined pulse sequence;
transmitting means for transmitting an RF pulse to excite nuclear spins in an object according to said predetermined pulse sequence;
receiving means for receiving a magnetic resonance echo signal from said region;
characterised by:
sequence control means for carrying out said predetermined pulse sequence, said pulse sequence inducing a plurality of echo signals on a predetermined trajectory, each of said echo signals having a different phase encoding, said echo signals from a plurality of different trajectories being obtained, said trajectories interleaving one another, a cycle of obtaining said echo signals from the trajectories being repeated;
data ordering means for ordering said echo signals according to a predetermined order, wherein one of the trajectory echo signals obtained in the cycle is replaced by a trajectory echo signal obtained in another cycle and the replaced trajectory echo signal is ordered to be located on a predetermined location on the Fourier space; and
reconstruction means for reconstructing a magnetic resonance image from echo signals from a first cycle and a fresh magnetic resonance image including some echo signals from the first cycle, with echo signals from a replaced trajectory from a subsequent cycle each time one set of echo signals is replaced;
whereby magnetic resonance images are continuously reconstructed.

Additional objects and advantages of the present invention will be set forth in the description which follows, and in part will be obvious from the description, or may be learned by practice of the invention.

Some embodiments of the invention will now be described by way of example with reference to the accompanying drawings, in which:

Figures 1a and 1b show a block diagram of a first embodiment of the present invention.

Figures 2 and 3 are a pulse sequence chart and a locus of trajectories, respectively, of Interleave Scan method used in the first embodiment of the present invention.

Figure 4 shows a block diagram of a second embodiment of the present invention.

Figure 5 shows a locus of trajectories according to the second embodiment of the present invention.

Figure 6 is a timing chart showing an electrocardiogram and sampling points according to the second embodiment of the present invention.

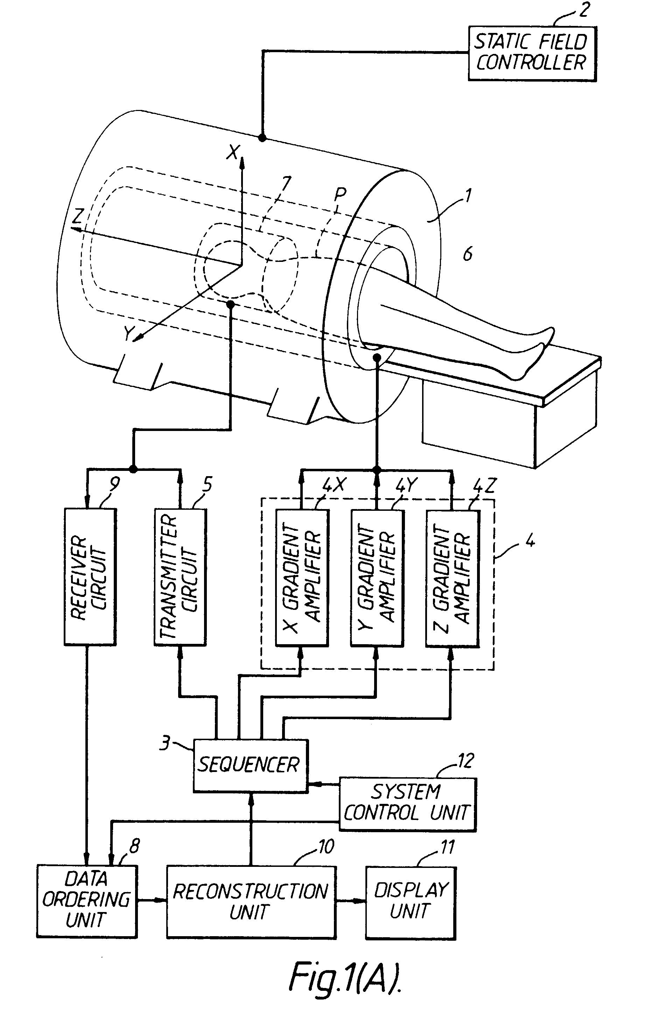

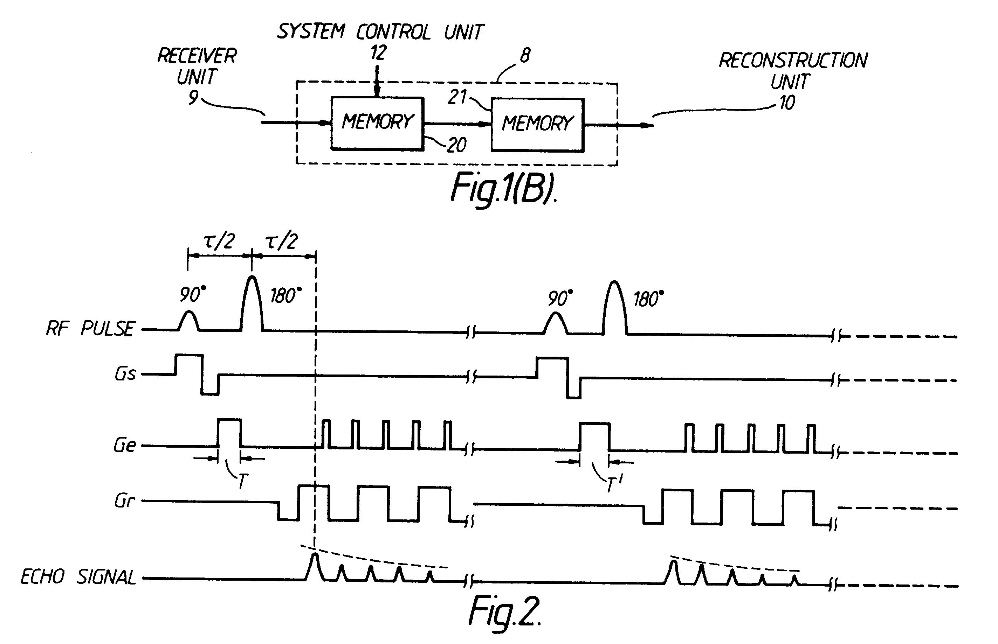

Referring now to Figs. 1 (A), (B), 2 and 3, a first embodiment of the present invention will be described. A magnet assembly 1 driven by a static field controller 2 provides a static magnetic field to the area to be examined. A sequencer 3 memorizes pulse sequences, for example, as shown in Fig. 2 and provides control signals to a gradient amplifier 4, consisting of three elements 4x, 4y and 4z, and an RF transmitter circuit 5 according to the pulse sequence. The gradient amplifier 4 drives a gradient coil system 6 for generating a gradient magnetic field to provide position information of a region in which magnetic resonance signals are induced. The gradient coil system 6 also consists of three elements corresponding to x-, y- and z-axis, respectively (not shown in Fig. 1 (A)). The transmitter circuit 5 provides RF signals to and receives induced echo signals from an RF probe 7. The RF probe 7, which may consists of a transmitter coil and a receiver coil and/or a transmitter-receiver coil, transmits RF pulses and detects induced echo signals. The detected echo signals are provided into a data ordering unit 8 via a receiver circuit 9 to be ordered. The ordered echo signal data are provided into a reconstruction unit 10 to reconstruct a magnetic resonance image of a patient P by carrying out a reconstruction process, for example, two-dimensional Fourier transform. The reconstructed image is displayed on a display unit 11. A system control unit 12 provides control signals to the sequence 3 and the data ordering unit 8.

Fig. 1 (B) shows an example of a detailed block diagram of the data ordering unit 8. Echo data from the receiver circuit 9 are temporarily stored in a memory unit 20. Then data selected according to control signals from the system control unit 12 are provided into a memory unit 21. The memory unit 21 has address corresponding to the coordinate system of the Fourier space. According to the signal magnitude, the frequency and the phase information of the echo signal data, the memory unit 21 recognises the address for the input data and the data are stored in the corresponding address.

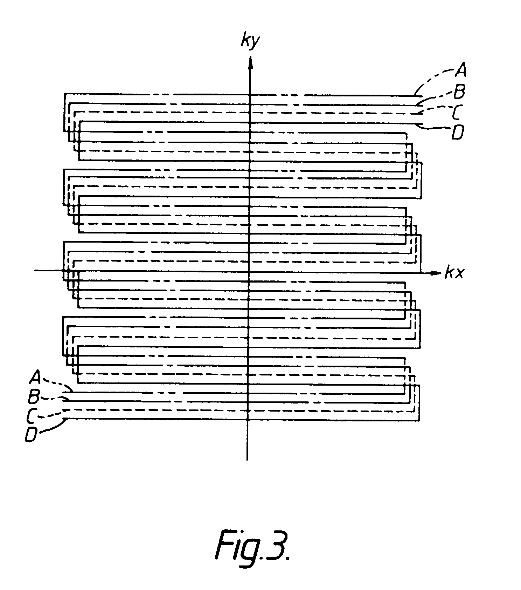

Fig. 2 shows an example of a pulse sequence used in the present invention. In Fig. 2, Gr, Ge and Gs correspond to read, phase-encode and slice gradient, respectively. A 90° RF pulse excites spins in a selected slice and an echo signal is obtained after a period T during the supply of the read gradient Gr. Repeatedly supplying the phase-encode gradient pulse signals Ge and reversing the direction of the read gradient Gr, a train of echo signals are induced and sampled along Trajectory A as shown in Fig. 3.

Trajectory B, which interleaves Trajectory A, is sampled with a pulse sequence in which the duration period T' of the initial phase-encode Ge is longer than T of Trajectory A to shift the trajectory along the ky axis on the Fourier space. Otherwise, the magnitude of the initial phase-encode gradient Ge may be larger to shift the trajectory. Trajectories C and D are also sampled in the similar manner. Consequently, data A1, B1, C1 and D1 are obtained along Trajectories A, B, C and D, respectively, and stored in the memory unit 20.

The stored data A1, B1, C1 and D1 are read out and provided into the memory unit 21 in the respective address corresponding to the coordinates of the Fourier space. Data A1, B1, C1 and D1 are read out from the memory unit 21 and input into the reconstruction unit 10. The reconstruction unit 10 reconstructs a first magnetic resonance image from data A1, B1, C1 and D1.

The cycle of sampling trajectories A, B, C and D is repeated a plurality of times to observe changes in the region in the patient P for a long period. In the second cycle, data A2, which is sampled along Trajectory A, is obtained first and stored in the memory unit 20. Data A2 is read out and provided to the memory unit 21 to be stored. In the memory unit 21, the stored data A1 is replaced by the newly input data A2. Then, data A2, B1, C1 and D1 are provided to the reconstruction unit 10. Subsequently obtained data B2 replace data B1 in the memory unit 21 and a third image is reconstructed from data A2, B2, C1 and D1.

As shown above, new images are obtained continuously. The first embodiment of the present invention can obtain four images during the period between an excitation and the next excitation, while the prior art could obtain one during the same period. Thus, the first embodiment can provide a magnetic resonance imaging apparatus which is improved four times in the frame rate.

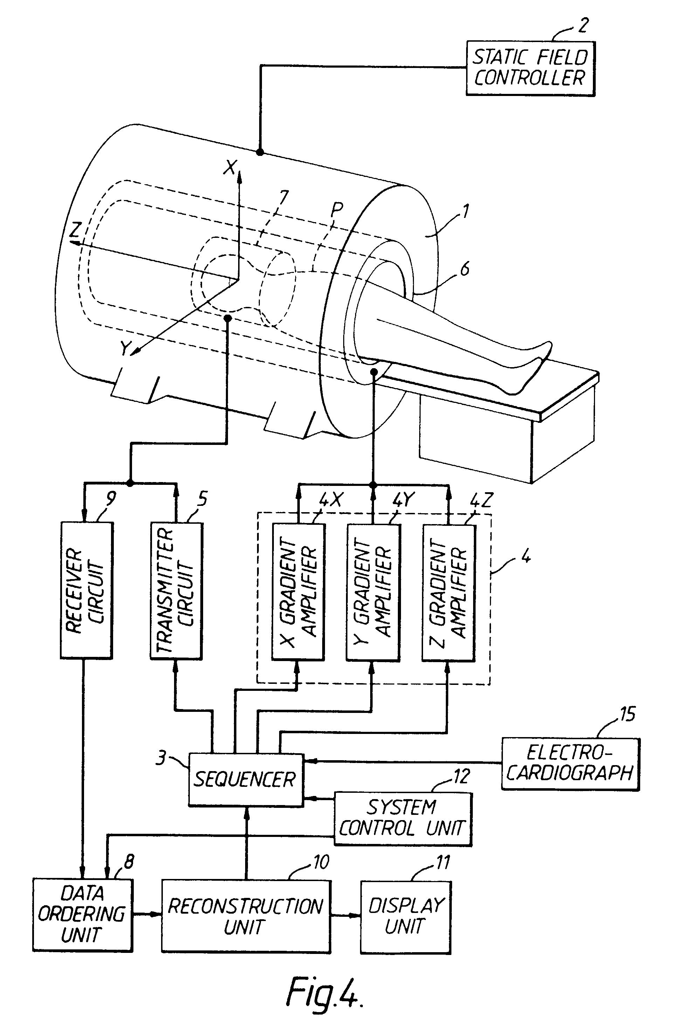

Referring now to Figs. 4, 5 and 6, a second embodiment of the present invention will be described. This embodiment is applied especially to obtaining images of the organ moving frequently, for example, a heart. The structure in Fig. 4 is same as Fig. 1 except for an electrocardiograph 15 for detecting heartbeats and controlling the sequencer 3.

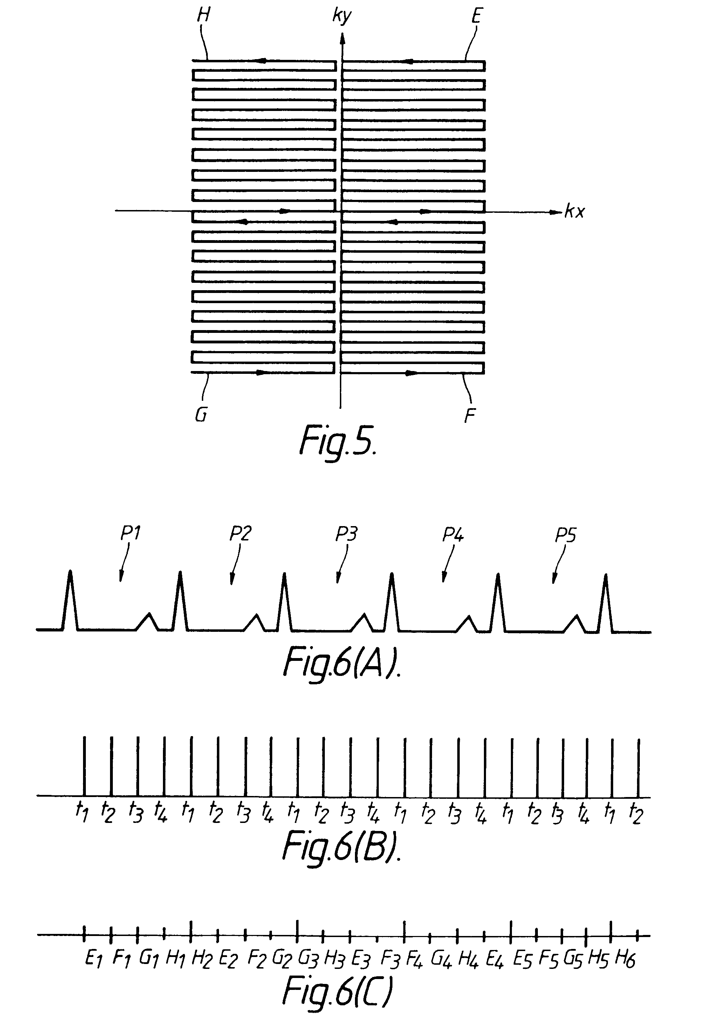

This embodiment employs four-tile Mosaic Scan which divides the Fourier space into four rectangular tile trajectories and the four tiles produce a magnetic resonance image as shown in Fig. 5. Fig. 6 (A) shows output signals from the electrocardiograph 15 indicating cardiac cycles of a patient. Each cardiac cycle is divided into four small cardiac delay phases t1-t4 as shown in Fig. 6 (B). Data of each trajectory are sampled during one of the cardiac delay phases t1-t4 in synchronism with the output signal of the electrocardiograph 15 as shown in Fig. 6 (C).

The order of sampling the trajectories is decided such that one of four trajectories is sampled at each cardiac delay phase and every trajectory at every cardiac delay phase is sampled in four cardiac cycles P1-P4. This order may be predetermined in the sequencer 3. During the first cardiac cycle P1 data of the tiles are sampled in order of E1-F1-G1-H1, the second cycle P2 H2-E2-F2-G2, the third cycle P3 G3-H3-E3-F3 and the fourth cycle P4 F4-G4-H4-E4, and each data is stored in the memory unit 20.

Data E1, H2, G3 and F4, each corresponding to the cardiac delay phase p1, are read out from the memory unit 20 and stored in the corresponding address in the memory unit 21. Then, data E1, F4, G3 and H2 are read out from the memory unit 21 and an image corresponding to the cardiac phase p1 is obtained by reconstruction unit 10.

When data E1, F4, G3 and H2 is read out from the memory unit 21, data E2, F1, G4 and H3, each corresponding to the cardiac phase p2, replace data formerly stored in the memory unit 21. Then an image corresponding to the phase p2 is obtained. In the similar manner, images corresponding to the phases p3 and p4 are obtained from data E3-F2-G1-H4 and E4-F3-G2-H1, respectively.

Thus, by the second embodiment, data of tiles E, F, G and H at each cardiac phases are obtained during four cardiac cycles and four magnetic resonance images are obtained, while the conventional MRI apparatus produced only one image for the same period. This embodiment improves the frame rate four times comparing with the conventional system, while the spacial resolution is not lowered.

In the above embodiment, after the fourth cardiac cycle, data of the fifth cardiac cycle may be obtained and the other four images can be obtained from data of the second to the fifth cycles. This enables the observation of the change in the patient for a longer period.

Further, this embodiment can be applied to images of abdomen by providing a respiration sensor, for example a motion sensor attached to the patient's body, instead of an electrocardiograph.

As described above, this embodiment improves the frame rate comparing with the conventional system, while the spatial resolution is not lowered. In addition, in the present invention the scan method is not limited to the above embodiments. Each embodiment may employ Mosaic Scan method or Interleave Scan method. As the pulse sequence used in the embodiments of the present invention, not only EPI method but also RARE or GRASE, etc. may be adopted. The number of trajectories dividing the Fourier space also is not limited to the above description. Further, more than two trajectory data may be replaced at once.

Numerous modifications and variations of the present invention are possible in light of the above-described teachings. It is therefore to be understood that, within the scope of the appended claims, the present invention can be practiced in a manner other than as specifically described herein.

## Claims

1. A method for magnetic resonance imaging comprising the steps of:
(a) applying a static magnetic field;
(b) applying an excitation pulse with a gradient field to excite nuclear spins in a region to be examined;
(c) reversing the direction of said excited nuclear spins repeatedly to induce a plurality of echo signals, said echo signals corresponding to a predetermined trajectory on the Fourier space, each of said echo signals having a different phase encoding;
(d) sampling said echo signals;
characterised by the steps of:
(e) repeating the steps (b)-(d) to obtain sets of echo signal data of a plurality of different trajectories which are interleaved with one another;
(f) repeating a cycle of the steps (b)-(e) to obtain further sets of echo signal data on the same trajectories as the previous cycle;
(g) replacing each set of trajectory data obtained in the step (e) in turn, by the corresponding set of trajectory data obtained in step (f), both sets of trajectory data being located on the same trajectory; and
(h) reconstructing a fresh magnetic resonance image each time one of the sets of data has been replaced.

2. A method for magnetic resonance imaging according to claim 1, wherein said step (e) comprises a first storing step for storing said sampled echo data, selecting step for selecting data to be reconstructed from said stored data and a second storing step for storing said selected data.

3. A method for magnetic resonance imaging according to claim 2, wherein said selected data are stored according to the coordinates of the Fourier space in said second storing step.

4. A method for magnetic resonance imaging according to claim 1, wherein said steps (b)-(d) are carried out in synchronism with motion of a patient and sampled data are selected according to said motion.

5. A method for magnetic resonance imaging according to claim 4, wherein data corresponding to the same motion phase are selected and ordered.

6. A method for magnetic resonance imaging according to claim 4, wherein at least one of said sets of trajectory data is replaced by data corresponding to the same trajectory at a different motion cycle.

7. A method for magnetic resonance imaging according to claim 4, wherein said motion is caused by heartbeats and detected by an electrocardiograph.

8. A method for magnetic resonance imaging according to claim 4, wherein said motion is caused by respiration and detected by a respiration sensor.

9. An apparatus for magnetic resonance imaging comprising:
static field generating means for generating a static magnetic field in a region to be examined;
gradient field generating means for generating a gradient magnetic field according to a predetermined pulse sequence;
transmitting means for transmitting an RF pulse to excite nuclear spins in an object according to said predetermined pulse sequence;
receiving means for receiving a magnetic resonance echo signal from said region;
characterised by:
sequence control means for carrying out said predetermined pulse sequence, said pulse sequence inducing a plurality of echo signals on a predetermined trajectory, each of said echo signals having a different phase encoding, said echo signals from a plurality of different trajectories being obtained, said trajectories interleaving one another, a cycle of obtaining said echo signals from the trajectories being repeated;
data ordering means for ordering said echo signals according to a predetermined order, wherein one of the trajectory echo signals obtained in the cycle is replaced by a trajectory echo signal obtained in another cycle and the replaced trajectory echo signal is ordered to be located on a predetermined location on the Fourier space; and
reconstruction means for reconstructing a magnetic resonance image from echo signals from a first cycle and a fresh magnetic resonance image including some echo signals from the first cycle, with echo signals from a replaced trajectory from a subsequent cycle each time one set of echo signals is replaced;
whereby magnetic resonance images are continuously reconstructed.

10. An apparatus for magnetic resonance imaging according to claim 9, wherein said ordering means comprising a first storing means for storing said sampled echo data and a second storing means for storing data selected from data stored in said first storing means.

11. An apparatus for magnetic resonance imaging according to claim 10, wherein said second storing means stores said selected data according to the coordinates of the Fourier space.

12. An apparatus for magnetic resonance imaging according to claim 9, wherein said sequence control means operates in synchronism with motion of a patient; and
further comprising motion detecting means for detecting said motion.

13. An apparatus for magnetic resonance imaging according to claim 12, wherein said data ordering means selects and orders data corresponding to the same motion phase.

14. An apparatus for magnetic resonance imaging according to claim 12, wherein at least one of said selected data is replaced by data corresponding to the same trajectory and the different motion cycle.

15. An apparatus for magnetic resonance imaging according to claim 12, wherein said motion is caused by heartbeat and further comprises an electrocardiograph for detecting said heartbeat.

16. An apparatus for magnetic resonance imaging according to claim 12, wherein said motion is caused by respiration and further comprises a respiration sensor for detecting said respiration.

## Patentansprüche

1. Verfahren zur Bilderzeugung mittels magnetischer Resonanz, mit den Schritten:
(a) Erzeugen eines statischen Magnetfeldes;
(b) Erzeugen eines Anregungsimpulses mit einem Gradientenfeld, um in einem zu untersuchenden Gebiet Kerndrehimpulse anzuregen;
(c) wiederholtes Umkehren der Richtung der angeregten Kerndrehimpulse, um eine Anzahl von Echosignalen zu induzieren, wobei die Echosignale einer vorbestimmten Trajektorie im Fourier-Raum entsprechen, wobei jedes der Echosignale eine andere Phasen-Kodierung hat;
(d) Abtasten der Echosignale;
**gekennzeichnet durch** die Schritte:
(e) Wiederholen der Schritte (b)-(d), um Sätze von Echosignaldaten von einer Anzahl verschiedener Trajektorien zu erhalten, die gegenseitig überlagert sind;
(f) Wiederholen eines Zyklus der Schritte (b)-(e), um weitere Sätze von Echosignaldaten der gleichen Trajektorien wie in dem vorhergehenden Zyklus zu erhalten;
(g) Ersetzen von jedem Satz von Trajektorie-Daten, die in dem Schritt (e) erhalten wurden, durch den entsprechenden Satz von Trajektorie-Daten, der in Schritt (f) erhalten wurde, wobei sich beide Sätze von Trajektorie-Daten auf der gleichen Trajektorie befinden; und
(h) Rekonstruieren eines neuen Magnetresonanzbildes immer dann, wenn einer der Datensätze ersetzt wurde.

2. Verfahren zur Bilderzeugung mittels magnetischer Resonanz nach Anspruch 1, wobei Schritt (e) einen ersten Speicherschritt zum Speichern der abgetasteten Echodaten, einen Auswahlschritt zum Auswählen von Daten, die aus den gespeicherten Daten zu rekonstruieren sind, und einen zweiten Speicherschritt zum Speichern der ausgewählten Daten umfaßt.

3. Verfahren zur Bilderzeugung mittels magnetischer Resonanz nach Anspruch 2, bei dem im zweiten Speicherschritt die ausgewählten Daten entsprechend der Koordinaten des Fourier-Raums gespeichert werden.

4. Verfahren zur Bilderzeugung mittels magnetischer Resonanz nach Anspruch 1, bei dem die Schritte (b)-(d) synchron mit der Bewegung des Patienten durchgeführt und abgetastete Daten entsprechend dieser Bewegung ausgewählt werden.

5. Verfahren zur Bilderzeugung mittels magnetischer Resonanz nach Anspruch 4, bei dem Daten, die der gleichen Bewegungsphase entsprechen, ausgewählt und sortiert werden.

6. Verfahren zur Bilderzeugung mittels magnetischer Resonanz nach Anspruch 4, bei dem zumindest einer der Sätze von Trajektorie-Daten durch Daten ersetzt wird, die der gleichen Trajektorie in einem anderen Bewegungszyklus entsprechen.

7. Verfahren zur Bilderzeugung mittels magnetischer Resonanz nach Anspruch 4, bei dem die Bewegung durch Herzschläge verursacht und durch einen Elektrokardiographen erfaßt werden.

8. Verfahren zur Bilderzeugung mittels magnetischer Resonanz nach Anspruch 4, bei dem die Bewegung durch Atmung verursacht und durch einen Respirationssensor erfaßt wird.

9. Vorrichtung zur Bilderzeugung mittels magnetischer Resonanz, mit:
einer Einrichtung, um in einem zu untersuchenden Gebiet ein statisches Magnetfeld zu erzeugen;
einer Einrichtung, um entsprechend einer vorbestimmten Impulssequenz ein Gradientenmagnetfeld zu erzeugen;
eine Sendereinrichtung zum Senden eines RF-Impulses, um in einem Gegenstand entsprechend dieser vorbestimmten Impulssequenz Kerndrehimpulse zu erregen;
einer Empfängereinrichtung zum Empfangen eines Magnetresonanzechosignals von diesem Gebiet;
**gekennzeichnet durch:**
eine Sequenzsteuereinrichtung zum Erzeugen dieser vorbestimmten Impulssequenz, wobei durch die Impulssequenz bei einer vorbestimmten Trajektorie eine Anzahl von Echosignalen induziert wird, wobei jedes dieser Echosignale eine andere Phasenkodierung hat, wobei die Echosignale von einer Anzahl von verschiedenen Trajektorien erhalten werden, wobei sich die Trajektorien gegenseitig überlagern, wobei wiederholt ein Zyklus durchgeführt wird, um Echosignale von den Trajektorien zu erhalten;
eine Datensortiereinrichtung, um die Echosignale entsprechend einer vorbestimmten Reihenfolge zu sortieren, wobei eines der in dem Zyklus erhaltenen Trajektorie-Echo-signale durch ein Trajektorie-Echosignal ersetzt wird, das in einem anderen Zyklus erhalten wird, und das ersetzte Trajektorie-Echosignal so einsortiert wird, um sich an einer bestimmten Stelle in dem Fourier-Raum zu befinden; und
eine Rekonstruktionseinrichtung zum Rekonstruieren eines Magnetresonanzbildes aus Echosignalen von einem ersten Zyklus und eines neuen Magnetresonanzbildes, das einige Echosignale von dem ersten Zyklus enthält, mit Echosignalen aus einer ersetzten Trajektorie von einem vorhergehenden Zyklus, wobei jedes Mal ein Satz von Echosignalen ersetzt wird;
wodurch fortlaufend magnetische Resonanzbilder rekonstruiert werden.

10. Vorrichtung zur Bilderzeugung mittels magnetischer Resonanz nach Anspruch 9, bei der die Sortiereinrichtung eine erste Speichereinrichtung zum Speichern der abgetasteten Echodaten und eine zweite Speichereinrichtung zum Speichern von Daten aufweist, die aus Daten ausgewählt sind, die in der ersten Speichereinrichtung gespeichert sind.

11. Vorrichtung zur Bilderzeugung mittels magnetischer Resonanz nach Anspruch 10, bei der in der zweiten Speichereinrichtung die ausgewählten Daten entsprechend der Koordinaten des Fourier-Raumes gespeichert sind.

12. Vorrichtung zur Bilderzeugung mittels magnetischer Resonanz nach Anspruch 9, bei der die Sequenzsteuereinrichtung synchron zur Bewegung des Patienten arbeitet; und
außerdem eine Bewegungserfassungseinrichtung zur Erfassung der Bewegung vorgesehen ist.

13. Vorrichtung zur Bilderzeugung mittels magnetischer Resonanz nach Anspruch 12, bei der die Datensortiereinrichtung Daten auswählt und sortiert, die der gleichen Bewegungsphase entsprechen.

14. Vorrichtung zur Bilderzeugung mittels magnetischer Resonanz nach Anspruch 12, bei der zumindest ein Datenelement der ausgewählten Daten durch ein Datenelement ersetzt wird, das der gleichen Trajektorie und dem anderen Bewegungszyklus entspricht.

15. Vorrichtung zur Bilderzeugung mittels magnetischer Resonanz nach Anspruch 12, bei der die Bewegung durch Herzschlag erzeugt wird und außerdem ein Elektrokardiograph vorgesehen ist, um die Herzschläge zu erfassen.

16. Vorrichtung zur Bilderzeugung mittels magnetischer Resonanz nach Anspruch 12, bei der die Bewegung durch Atmung erzeugt wird und außerdem ein Respirationssensor vorgesehen ist, um die Respiration zu erfassen.

## Revendications

1. Procédé pour la formation d'image de résonance magnétique comprenant les étapes consistant à :
(a) appliquer un champ magnétique statique ;
(b) appliquer une impulsion d'excitation avec un champ de gradient pour exciter des spins nucléaires dans une région à examiner ;
(c) inverser le sens desdits spins nucléaires excités de manière répétée pour induire une pluralité de signaux d'écho, lesdits signaux d'écho correspondant à une trajectoire prédéterminée sur l'espace de Fourier, chacun desdits signaux d'écho ayant un codage de phase différent ;
(d) échantillonner lesdits signaux d'écho ;
caractérisé par les étapes consistant à :
(e) répéter les étapes (b) à (d) pour obtenir des ensemble de données de signaux d'écho d'une pluralité de trajectoires différentes qui sont intercalées les unes avec les autres ;
(f) répéter un cycle des étapes (b) à (e) pour obtenir d'autres ensembles de données de signaux d'écho sur les mêmes trajectoires que le cycle précédent ;
(g) remplacer à son tour chaque ensemble de données de trajectoires obtenues à l'étape (e) par l'ensemble correspondant de données de trajectoires obtenues à l'étape (f), les deux ensembles de données de trajectoires étant situés sur la même trajectoire ; et
(h) reconstruire une nouvelle image de résonance magnétique à chaque fois que l'un des ensembles de données a été remplacé.

2. Procédé pour la formation d'image de résonance magnétique selon la revendication 1, dans lequel ladite étape (e) comprend une première étape de stockage pour stocker lesdites données d'écho échantillonnées, une étape de sélection pour sélectionner les données à reconstruire à partir desdites données stockées et une deuxième étape de stockage pour stocker lesdites données sélectionnées.

3. Procédé pour la formation d'image de résonance magnétique selon la revendication 2, dans lequel lesdites données sélectionnées sont stockées conformément aux coordonnées de l'espace de Fourier de ladite deuxième étape.

4. Procédé pour la formation d'image de résonance magnétique selon la revendication 1, dans lequel lesdites étapes (b) à (d) sont exécutées en synchronisme avec le mouvement d'un patient et les données échantillonnées sont sélectionnées en fonction dudit mouvement.

5. Procédé pour la formation d'image de résonance magnétique selon la revendication 4, dans lequel les données correspondant à la même phase de mouvement sont sélectionnées et ordonnées.

6. Procédé pour la formation d'image de résonance magnétique selon la revendication 4, dans lequel au moins d'un desdits ensembles de données de trajectoires est remplacé par des données correspondant à la même trajectoire à un cycle de mouvement différent.

7. Procédé pour la formation d'image de résonance magnétique selon la revendication 4, dans lequel ledit mouvement est provoqué par des battements cardiaques et détecté par un électrocardiographe.

8. Procédé pour la formation d'image de résonance magnétique selon la revendication 4, dans lequel ledit mouvement est provoqué par la respiration et détecté par un détecteur de respiration.

9. Dispositif pour la formation d'image de résonance magnétique comprenant :
des moyens de génération de champ statique pour générer un champ magnétique statique dans une région à examiner ;
des moyens de génération de champ de gradient pour générer un champ magnétique de gradient, conformément à une séquence d'impulsions prédéterminée ;
des moyens de transmission pour transmettre une impulsion HF pour exciter des spins nucléaires dans un objet, conformément à ladite séquence d'impulsions prédéterminée ;
des moyens de réception pour recevoir un signal d'écho de résonance magnétique depuis ladite région ;
caractérisé par :
des moyens de commande de séquence pour exécuter ladite séquence d'impulsions prédéterminée, ladite séquence d'impulsions comportant une pluralité de signaux d'écho sur une trajectoire prédéterminée, chacun desdits signaux d'écho ayant un codage de phase différent, lesdits signaux d'écho provenant d'une pluralité de trajectoires différentes étant obtenus, lesdites trajectoires s'intercalant les unes avec les autres, un cycle d'obtention desdits signaux d'écho des trajectoires étant répété ;
des moyens pour ordonner des données pour ordonner lesdits signaux d'écho selon un ordre prédéterminé, dans lequel l'un des signaux d'écho de trajectoire obtenu dans le cycle est remplacé par un signal d'écho de trajectoire obtenu dans un autre cycle et le signal d'écho de trajectoire remplacé est ordonné de manière à être situé à un emplacement prédéterminé sur l'espace de Fourier ; et
des moyens de reconstruction pour reconstruire une image de résonance magnétique à partir de signaux d'écho provenant d'un premier cycle et une nouvelle image de résonance magnétique comportant certains signaux d'écho provenant du premier cycle, les signaux d'écho d'une trajectoire remplacée provenant d'un cycle subséquent à chaque fois qu'un ensemble de signaux d'écho est remplacé ;
de façon que des images de résonance magnétique soient reconstruites de manière continue.

10. Dispositif pour la formation d'image de résonance magnétique selon la revendication 9, dans lequel lesdits moyens pour ordonner comprennent des premiers moyens de stockage pour stocker lesdites données d'écho échantillonnées et des deuxièmes moyens de stockage pour stocker des données sélectionnées à partir des données stockées dans lesdits premiers moyens de stockage.

11. Dispositif pour la formation d'image de résonance magnétique selon la revendication 10, dans lequel lesdits deuxièmes moyens de stockage stockent lesdites données sélectionnées conformément aux coordonnées de l'espace de Fourier.

12. Dispositif pour la formation d'image de résonance magnétique selon la revendication 9, dans lequel lesdits moyens de commande de séquence agissent en synchronisme avec le mouvement d'un patient ; et
comprenant en outre des moyens de détection de mouvement pour détecter ledit mouvement.

13. Dispositif pour la formation d'image de résonance magnétique selon la revendication 12, dans lequel lesdits moyens pour ordonner sélectionnent et ordonnent des données correspondant à la même phase de mouvement.

14. Dispositif pour la formation d'image de résonance magnétique selon la revendication 12, dans lequel au moins l'une desdites données sélectionnées est remplacée par des données correspondant à la même trajectoire et au cycle de mouvement différent.

15. Dispositif pour la formation d'image de résonance magnétique selon la revendication 12, dans lequel ledit mouvement est provoqué par un battement cardiaque et comprend en outre un électrocardiographe pour détecter ledit mouvement cardiaque.

16. Dispositif pour la formation d'image de résonance magnétique selon la revendication 12, dans lequel ledit mouvement est provoqué par la respiration et comprend en outre un détecteur de respiration pour détecter ladite respiration.
